Europäisches Patentamt

**European Patent Office**

**Office européen des brevets**

(11) Publication number: **0 131 404**
**A2**

(12) **EUROPEAN PATENT APPLICATION**

(21) Application number: **84304267.2**

(22) Date of filing: **25.06.84**

(51) Int. Cl.⁴: **G 02 B 6/10**

(30) Priority: **07.07.83 GB 8318470**

(43) Date of publication of application:
**16.01.85 Bulletin 85/3**

(84) Designated Contracting States:
**AT BE CH DE FR IT LI LU NL SE**

(71) Applicant: **STANDARD TELEPHONES AND CABLES
PUBLIC LIMITED COMPANY
190 Strand
London, WC2R 1DU(GB)**

(72) Inventor: **Extance, Philip
St. Thomas's Parsonage
Ancaster Way Cambridge(GB)**

(72) Inventor: **Jones, Roger Edward
20, High Street
Little Shelford Cambridge(GB)**

(72) Inventor: **Pitt, Gillies David
43 Farmadine
Saffron Walden Essex(GB)**

(74) Representative: **Laurence, Simon French
STC Patent Department Edinburgh Way
Harlow Essex CM20 2SH(GB)**

(54) **Fibre optic sensors.**

㊐ A fibre optic sensor in which the sensed parameter acts upon particles present in a plastics coating surrounding an optical fibre in such a way that the action modifies an optical propagation characteristic of the fibre. Thus the change in optical path length of the fibre included by the surrounding ferrite particle loaded plastics layer in the presence of a magnetic field provides the fibre with sensitivity to magnetic fields which can be detected by optical interferometry.

EP 0 131 404 A2

Croydon Printing Company Ltd

P. Extance - R.E. Jones
G.D. Pitt      2-2-41 EPC

FIBRE OPTIC SENSORS

This invention relates to fibre optic sensors. It has been shown that an optical fibre can be rendered sensitive to magnetic fields by encasing the bare fibre in a sheath of magnetostrictive metal. A change of magnetic field changes the physical length of the sheath. This change is transmitted to the fibre where it produces a change in the optical path length of that fibre. The change in optical path length is discernable by putting the optical fibre in one arm of an optical interferometer, typically a Mach-Zehnder interferometer.

A nickel or metallic glass film deposited by sputtering has provided the magnetostrictive sheath, but this has the drawback that sputtering is a relatively slow process to provide a layer of adequate thickness over the surface of a fibre which may be kilometres in length.

According to the present invention there is provided a fibre optic sensor provided by a packaged optical fibre possessing an internal optical waveguiding structure which is encased in one or more layers of plastics packaging wherein part or all of one or more of these plastics layers is loaded with particles which either provide an optical propagation characteristic of the fibre with a sensitivity to an applied environmental parameter, or modify the magnitude of an existing sensitivity.

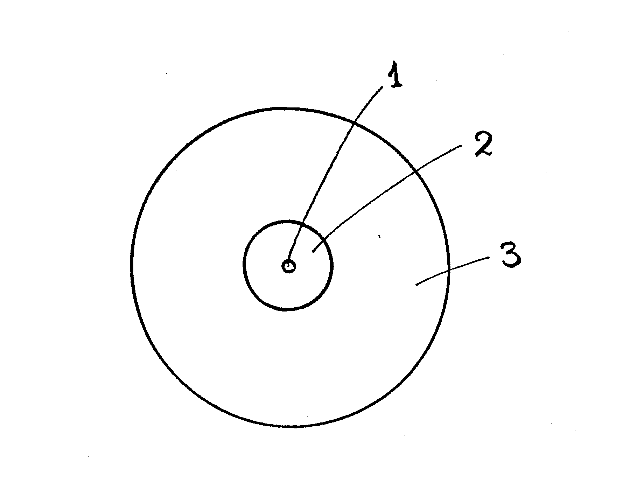

We have found that an acceptable degree of sensitivity to magnetic fields can be achieved by encasing the cladding of the optical fibre in a plastics coating, for instance of epoxy resin, loaded with a magnetostrictive powder, such as a ferrite, with the loading factor being less than 20% by weight so as to retain adequate flexibility for the plastics packaged fibre. A particular advantage of this approach is that the sensor can be made by adapting an existing processing stage of packaged optical fibre manufacture, namely a stage in which a plastics coating is applied to the fibre, rather than by introducing one or more additional stages to the manufacturing process. Preferably, though not necessarily, the application of the particle loaded plastics material is performed on line with the drawing of the fibre from preform or from a melt.

In a particular example the silica surface of a length of single mode silica fibre was provided over a distance of only 3 cm with a quick-setting epoxy coating loaded with less than 20% by weight with magnetite, having a particle size in the range 20 to 100 microns, which was cured in the presence of a longitudinally aligned magnetic field of about 1000 Gauss. When this fibre was mounted in one arm of a Mach-Zehnder system capable of detecting phase shifts down to the limit of about 2 milliradians, this small length of sensor was sufficient to make the instrument sensitive to magnetic fields down to a limit of about 0.1 gauss. Of course, a greater length of epoxy coating would give a proportionately greater sensitivity.

One of the factors affecting the magnitude of effect produced by a given concentration of the particulate loading will be the hardness or otherwise of the plastics matrix in which the particles are dispersed. We have calculated that typically the value of Young's modulus for the material of the plastics matrix (in its fully cured state) should lie in the range from 0.5 to 3.0 GPa. With a softer material, particularly at low particle concentrations, too much dimensional change of the particles tends to be accommodated by the plastics matrix rather than being transmitted to the optical fibre. On the other hand in the case of a sensor fibre whose length is large compared with its diameter, one or even more relatively soft plastics intermediary layers can be accommodated between the fibre and the particle loaded plastics layer because gross movement of the fibre within the packaging will not normally be possible, and hence the majority of any bulk change in length of the particle loaded layers will be transmitted to the fibre. Separation of the particle loaded layer from the fibre surface is desirable if the particles are liable to damage the surface of the fibre. With harder material, particularly at high particle concentrations, there is the problem of excessive stiffness. In this context it should be noted that for some sensor applications stiffness of the packaged fibre does not present serious drawback and under these circumstances it may be found convenient to coat the fibre with the particle loaded plastics material which is then partially cured to give it sufficient robustness for convenience of handling, and to complete the curing only when the sensor has been assembled in its operational shape.

The magnetostrictive particles are replaced by piezoelectric particles in order to provide a sensor responsive to electric fields rather than magnetic fields. In this case the alignment of the particles in the plastics matrix is brought about with the aid of an applied electric field. For some applications it may be advantageous to mix both types of particle so as to modify at the same time the sensitivity to both types of field. For example, if the bare fibre already has a sensitivity to electric fields, it can be advantageous when making a magnetic field sensor to include sufficient piezoelectric particles to nullify the electric field sensitivity so that spurious readings are not generated by the presence of extraneous electric fields.

For a sensor sensitive to temperature a further type of particle loading is provided by the use of particles of metal having a high coefficient of thermal expansion compared with that of the plastics matrix material in which they are embedded. Examples of suitable metals include iron and aluminium. Preferably these are incorporated in the plastics in the form of whiskers. These whiskers may be aligned by the flow properties used for coating the fibre with the particle loaded plastics material. In the case of the iron particles this alignment may be assisted by the additional employment of a magnetic field.

Another of the features of using particle loading of a plastics coating surrounding a fibre to make a sensor is that during the coating process the composition may be altered, for instance for coding the packaged fibre so that specific regions, possibly discrete regions, in its length have different specific characteristic responses. This variation may be in the composition, and/or proportion of the particle loading, and/or the composition and hence the hardness of the plastics matrix material. In the case of a distributed sensor arrangement, a particular advantage of this approach is that no splicing is required to insert the sensors into the transmission path. Another form of non-uniformity may be provided by arranging to have a non-circularly symmetric distribution of particles around the fibre so as to introduce differential effects to produce bending of the fibre in the presence of the sensed parameter. The non-uniformity of distribution around the fibre may be produced for instance by partitioning the flow of the particle load resin as it is introduced around the fibre or, in the case of particles requiring alignment by the application of an external field, by the use of a non-symmetric aligning field.

In the foregoing description use has been made of particles that change their shape in order to modify the optical path length of the sensor fibre. An alternative way of producing an optical response is to use a particulate loading of luminescent material, for instance electroluminescent, photoluminescent, or triboluminescent, in a region where the fibre is bent to the extent that light within the luminescence wavelength band is coupled into the fibre, thus forming a kind of microbend transducers.

0131404

CLAIMS:-

1.      A fibre optic sensor provided by a single mode optical fibre possessing an internal optical waveguiding structure which fibre is encased in one or more layers of plastics packaging characterised in that part or all of one or more of these plastics layers is loaded with particles which either provide an optical propagation characteristic of the fibre with a sensitivity to an applied environmental parameter, or modify the magnitude of an existing sensitivity.

2.      A fibre optic sensor as claimed in claim 1 wherein at least some of the particles provide an enhanced sensitivity to the environmental parameter.

3.      A fibre optic sensor as claimed in claim 1 or 2, wherein the particles are of two or more kinds responsive to different environmental parameters.

4.      A fibre optic sensor as claimed in claim 3 wherein at least one of the kinds of particles is present in a quantity and distribution such as to cancel an existing sensitivity of the fibre to a particular environmental parameter while another kind is present in a quantity and distribution such as to provide a sensitivity or an enhanced sensitivity to a different environmental parameter.

5.      A fibre optic sensor as claimed in any preceding claim wherein the particle distribution is non-uniform down the length of the fibre.

6.      A fibre optic sensor as claimed in claim 5 wherein the particle loading is in discrete lengths providing the elements of a distributed sensor.

7.      A fibre optic sensor as claimed in any preceding claim wherein the particle distribution is non-uniform around the circumference of the fibre.

8.      A fibre optic sensor as claimed in any preceding claim wherein the particles are present in the plastics layer in contact with the optical fibre.

9.      A fibre optic sensor as claimed in any claim of claims 1 to 7 wherein the particles are present in a plastics layer spaced from contact with the optical fibre by an intermediate plastics layer.

10.     A fibre optic sensor as claimed in any preceding claim wherein the particles have sizes in the range 20 to 100 microns.

11.     A fibre optic sensor as claimed in any preceding claim wherein the particle loading is less than 20% by weight of the plastics matrix in which the particles are dispersed.

12.     A fibre optic sensor as claimed in any preceding claim wherein the plastics matrix in which the particles are dispersed has a Young's modulus lying in the range from 0.5 to 3.0 GPa.

13.     A fibre optic sensor as claimed in any preceding claim wherein at least some of the particles are magnetostrictive.

14.     A fibre optic sensor as claimed in any preceding claim wherein at least some of the particles are piezoelectric.

15.     A fibre optic sensor as claimed in any preceding claim wherein at least some of the particles have a coefficient of thermal expansion that is large compared with that of the plastics matrix in which they are dispersed.

16.     A fibre optic sensor as claimed in any preceding claim wherein at least some of the particles are aligned by an applied magnetic field.

17.     A fibre optic sensor as claimed in any preceding claim wherein at least some of the particles are aligned by an applied electric field.

18.     A fibre optic sensor as claimed in any preceding claim wherein at least some of the particles are acicular and are aligned by the flow of the plastics matrix material in which they are dispersed as that material is dispensed around the fibre.

19.      A fibre optic sensor as claimed in any preceding claim wherein the sensed environmental parameter acts upon the particles in such a way as to change the optical path length of the region of the optical fibre encased by the particles.

20.      A fibre optic sensor as claimed in claim 19 which is a magnetic field sensor.

21.    ' A fibre optic sensor as claimed in claim 19 which is an electric field sensor.

22.      A fibre optic sensor as claimed in claim 19 which is a temperature sensor.

23.      A fibre optic sensor as claimed in any claim of claims 1 to 12 wherein the particles are luminescent and are in a region where the fibre is bent to the extent that the light within the luminescence wavelength band is coupled into the fibre.

24.      A fibre optic sensor as claimed in claim 23 wherein the particles are electroluminescent.

25.      A fibre optic sensor as claimed in claim 23 wherein the particles are photoluminescent.

26.      A fibre optic sensor as claimed in claim 23 wherein the particles are triboluminescent.

P. Extance
R.E. Jones
G.D. Pitt
2-2-41.